## Europäisches Patentamt
### European Patent Office
### Office européen des brevets

(11) Publication number: **0 080 415 B1**

(12) **EUROPEAN PATENT SPECIFICATION**

(45) Date of publication of patent specification: **10.10.90**

(51) Int. Cl.⁵: **G 11 C 11/34, G 11 C 17/00**

(21) Application number: **82402116.6**

(22) Date of filing: **22.11.82**

(60) **Divisional application 88118696.9 filed on 22/11/82.**

(54) Self-refreshing memory cell.

(30) Priority: **23.11.81 US 324343**
**23.11.81 US 324344**

(43) Date of publication of application:
**01.06.83 Bulletin 83/22**

(45) Publication of the grant of the patent:
**10.10.90 Bulletin 90/41**

(84) Designated Contracting States:
**DE FR GB IT NL**

(56) References cited:
**EP-A-0 028 935**
**GB-A-2 000 407**
**GB-A-2 058 451**

**IEEE INTERNATIONAL SOLID-STATE CIRCUITS CONFERENCE, February 1978, Digest of Technical Papers, pages 108-109, New York, US; E. HARARI et al.: "Static and nonvolatile memories"**

(73) Proprietor: **FAIRCHILD SEMICONDUCTOR CORPORATION**
**10400 Ridgeview Court P.O. Box 1500**
**Cupertino, California 95014 (US)**

(72) Inventor: **Tickle, Andrew C.**
**1222 Richardson Avenue**
**Los Altos California 94022 (US)**

(74) Representative: **Sparing Röhl Henseler Patentanwälte European Patent Attorneys Rethelstrasse 123 D-4000 Düsseldorf 1 (DE)**

Courier Press, Leamington Spa, England.

**Description**

Background of the invention

Field of the invention

This invention relates to a self-refreshing memory cell suitable for use in an integrated circuit with increased packing density over circuits of the prior art, and to its method of operation.

Prior art

Bistable memory cells are well known. Such cells are disclosed, for example, in United States Patent No. 3,562,721 to Norman, issued February 9, 1971. The Normal cell comprises two cross-coupled bipolar transistors connected in what has now become a standard bistable flip-flop configuration. The collector of one bipolar transistor in the cell is connected to the base of the other transistor and the emitters of the two transistors are grounded. When one transistor turns on, the collector voltage on that transistor drops thereby turning off the other transistor. The collector voltage on the off transistor then rises turning on harder the "on" transistor. The state of the cell is changed by pulsing simultaneously the collector of the cross-coupled transistor and a selected switching transistor. The state of the cell is sensed by determining the voltages on the collectors of the two transistors.

Since the disclosure of this long established cell, new bistable cells have appeared, including cells using a charge stored at the interface between two dissimilar dielectrics (see, for example, U.S. Patent No. 3,641,512 issued February 8, 1972 on an invention of Frohman-Bentchkowsky) and cells using so-called "floating gates" which are conductive gates insulated from the active components of the transistor by dielectric. The charge on the floating gate is often controlled by controlling the potential on an overlying word line in such a manner as to either draw a charge from an underlying source to the floating gate or expell charge from the floating gate to the source. Such devices, often making use of electron tunnelling through a thin dielectric, are described, for example, in an article entitled "Low Power EEPROM Can Be Reprogrammed Fast", published in Electronics, July 31, 1980, by Shelton. The EEPROM, short for "Electrically Erasable Programmable Read Only Memory", has distinct advantages over the prior art memories in that the EEPROM can be erased by programming internal to the chip whereas the standard EPROM is erasable only by UV light from an external source. In addition, the EEPROM lends itself to rapid reprogramming in a simple manner with portable equipment.

Publication E—A—28 935 discloses an electronic memory which exhibits the features set forth in the pre-characterizing portion of patent claim 1. The higher potential is applied to the control gate of the transistor; another publication GB—A—2 000 407 applies the higher potential to the power supply.

Both said publications provide data storage in volatile or non-volatile manner. However, data stored in non-volatile modus is the opposite to data stored in volatile modus. Information must be recorded as to the manner in which the data was stored in order to know whether data upon retrieval is or is not to be inverted.

The present invention overcomes this disadvantage by the features set forth in the characterizing portion of patent claim 1. Dependent claims 2 through 4 define preferred details of the concept of the invention.

This invention provides structures which resemble conventional cross-coupled flip-flops. However, contrary to such flip-flops, the coupling in the flip-flops of this invention is AC rather than DC. The flip-flops of this invention may be written into and read from in a conventional manner. However, since the drain voltage on the active element which is off is always in the same direction as for writing, drain disturb reinforces writing assuming that the volatile information stored in the cell is the same as the non-volatile state of the cell. Should these two states be different, then a normal disturb will degrade, rather than reinforce, writing.

This invention will be more fully understood in light of the following description taken together with the drawings.

Description of the drawings

Figure 1 shows the circuit schematic of a cell of this invention;

Figure 2 shows a top view of the integrated circuit semiconductor implementation of the cross-coupled structure shown schematically in Figure 1;

Figure 3 shows graphically an example of the change in threshold voltage with time for the structure of this invention;

Figures 4 and 5 illustrate in cross-section the floating gate and tunnel oxide structures of a type useful in the semiconductor integrated circuit implementations of the circuits of this invention.

Detailed description

This invention will be described in conjunction with a specific embodiment. It should be understood, however, that this description is illustrative only and is not meant to limit the scope of the invention.

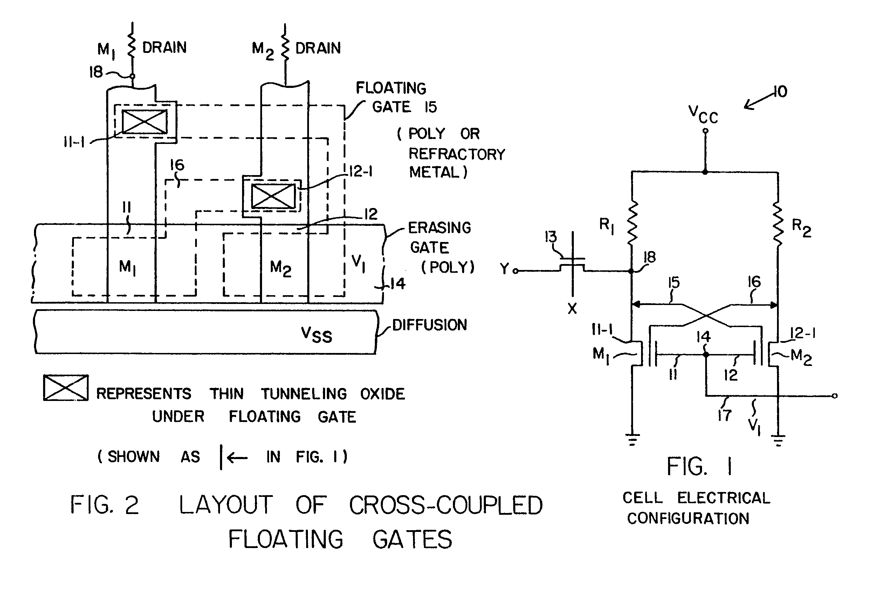

As shown in Figure 1, bistable memory cell 10 comprises two MOS transistors $M_1$ and $M_2$. $M_1$ and $M_2$ are preferably N-channel devices although these devices could also be P-channel with appropriate changes in the polarities of the voltages. $M_1$ has its source grounded and its drain 11-1 connected to one terminal of

resistor $R_1$, the other terminal of which is connected to power supply $V_{cc}$. A gate 11 is separate by insulation from an underlying floating gate 16. One portion of floating gate 16 is separated from the drain of $M_2$ by means of a thin tunnel oxide, typically from 500 to 2000 nm (50 to 200 angstroms) thick, above a portion of the drain of transistor $M_2$. The gate 11 of transistor $M_1$ is connected at node 14 to the gate 12 of transistor $M_2$ and also to voltage source $V_1$ by means of lead 17.

Transistor $M_2$ has its source grounded and its drain 12-1 connected to one terminal of resistor $R_2$, the other terminal of which is also connected to voltage source $V_{cc}$. Floating gate 15 is sandwiched between gate 12 and the channel region of transistor $M_2$ but is insulated from both gate 12 and the channel region by dielectric. One portion of floating gate 15 is separated from the drain of transistor $M_1$ by means of a thin tunnel oxide (500—2000 nm) over a portion of the drain.

In the operation of the circuit of Figure 1, an input signal Y is transmitted to node 18 between resistor $R_1$ and the drain of transistor $M_1$ through an MOS switching transistor 13 of conventional design.

Figure 2 shows in top view the layout of one embodiment of the circuit shown schematically in Figure 1. In Figure 2, portions of the layout corresponding to circuit components in Figure 1 are numbered identically. Ground in Figure 1 is shown in Figure 2 as a common source diffusion labelled $V_{ss}$. The drain regions of the two transistors $M_1$ and $M_2$ are shown in Figure 2 as regions 11-1 and 12-1, respectively. The gates 11 and 12 of transistors $M_1$ and $M_2$ in Figure 1, respectively, are shown in Figure 2a as a common conductive line 14 with regions 11 and 12 overlying the corresponding channel regions of transistors $M_1$ and $M_2$ so as to act as the gate electrodes. The drains of transistors $M_1$ and $M_2$ are formed by diffusion or by ion-implantation using well-known techniques and extend, in a well-known manner, to contact resistors $R_1$ and $R_2$ respectively. Resistors $R_1$ and $R_2$ can be formed in any one of several ways and can comprise, for example, deposited resistors such as of polysilicon or nichrome on the top surface of the device insulated from the underlying substrate by dielectric or diffused resistors within the semiconductor structure itself or active load devices of well-known construction. External signals on lead Y, accessed through transistor 13 to the cell, read and write the flip-flop in a conventional manner.

Two types of memories are commonly employed—volatile and non-volatile. A volatile memory is one which loses the information stored therein immediately upon loss of power. A non-volatile memory is one which retains the information stored therein despite the loss of power. As will be seen shortly, memory cell 10 is capable of storing both volatile and non-volatile information.

In describing the operation of memory cell 10 in this specification, certain conventions will be adopted. Thus, the storage in a volatile manner of a logical one within memory cell 10 of Figure 1 will correspond to transistor $M_1$ nonconducting and transistor $M_2$ conducting. Similarly, the storage in a volatile manner of a logical zero within memory cell 10 will correspond to transistor $M_1$ conducting and transistor $M_2$ nonconducting. The storage in a non-volatile manner of a logical one within memory cell 10 corresponds to a threshold voltage of transistor $M_2$ which is less than the threshold voltage of transistor $M_1$, and the storage in a non-volatile manner of a logical zero corresponds to a threshold voltage of transistor $M_2$ which is greater than the threshold voltage of transistor $M_1$. These conventions are summarized in Table I (wherein $V_t$ represents threshold voltage).

TABLE I
Cell 10 (Figure 1)

|  |  | $M_1$ | $M_2$ |
|---|---|---|---|
| Volatile storage | $\{$ 0 | On | Off |
|  | 1 | Off | On |
| Non-volatile storage | $\{$ 0 | $V_{t1}$ | $< V_{t2}$ |
|  | 1 | $V_{t1}$ | $> V_{t2}$ |

The operation of the memory cell 10 as a volatile RAM is as follows. A data input signal is provided on lead Y (Figure 1) through gating transistor 13 to node 18. This data input signal is high and is approximately equal to $V_{cc}$ (e.g. both the high data input signal and $V_{cc}$ are approximately 5 volts) if a one is to be written into cell 10 and is low (e.g. approximately 0 volts) if a zero is to be written into cell 10. The data input signal on node 18 is capacitively coupled to floating gate 15 of transistor $M_2$.

If the data input signal on node 18 is low, and if a normal gate voltage $V_1$, typically 5 volts, is applied to gates 11 and 12 of transistors $M_1$ and $M_2$ respectively, the voltages on gate 12 and floating gate 15 of transistor $M_2$ are insufficient to turn on transistor $M_2$, thereby causing the voltage on drain 12-1 of transistor $M_2$ to be substantially equal to $V_{cc}$. This high voltage on drain 12-1 is capacitively coupled through tunnel oxide to floating gate 16, thus increasing the gate potential of transistor $M_1$ and thus, together with the low signal voltage on node 18, causing transistor $M_1$ to conduct. With transistor $M_1$ conducting, the voltage on drain 11-1 is essentially ground. The low voltage on drain 11-1 is capacitively coupled through tunnel oxide to floating gate 15 reinforcing the turning off of $M_2$. Accordingly, transistor $M_2$ remains off and transistor $M_1$

remains on after removal of the low data input voltage from lead Y. Thus, with the application of a low data input voltage on node 18 from lead Y through gating transistor 13, a logical zero is written into cell 10.

In a similar manner, if it is desired to store in a volatile manner a logical 1 within memory cell 10, a high voltage is applied on lead Y to node 18. With a normal gate voltage $V_1$ of approximately 5 volts applied to gates 11 and 12 of transistors $M_1$ and $M_2$ respectively, the high voltage on node 18 is capacitively caoupled through tunnel oxide to floating gate 15, thus increasing the gate potential of transistor $M_2$, causing transistor $M_2$ to conduct. With transistor $M_2$ conducting, the voltage on drain 12-1 is substantially ground. This low voltage on drain 12-1 is capacitively coupled through tunnel oxide to floating gate 16, thus causing a low gate voltage on transistor $M_1$, thus causing transistor $M_1$ to remain off. With transistor $M_1$ turned off, the voltage on node 18 remains substantially $V_{cc}$, even in the absence of the high data input signal from lead Y. Thus, transistor $M_2$ remains on and transistor $M_1$ remains off after the removal of the high data input signal from node 18. In this manner, a logical one is stored in a volatile manner in cell 10.

The state of the data stored in memory cell 10 in a volatile manner is determined by the voltage on node 18. To read cell 10, node 18 is connected through gating transistor 13 to lead Y which in turn is connected to a suitable sense amplifier of well known design (not shown). The sense amplifier is capable of providing an output signal corresponding to a logical 1 when node 18 is high (transistor $M_1$ nonconducting and transistor $M_2$ conducting), and an output signal corresponding to a logical low when the voltage on node 18 is low (transistor $M_1$ conducting and transistor $M_2$ nonconducting).

In the volatile operation of memory cell 10, the voltages applied to node 18 and node 14 are not sufficiently high to cause electrons to tunnel through the tunnel oxide between drain 11-1 and floating gate 15, or between drain 12-1 and floating gate 16. The situation is different, however, when information is to be stored in memory cell 10 in a non-volatile manner.

Non-volatile writing into the bistable cell 10 of Figure 1 takes place as follows. When $V_{cc}$ is raised to the writing voltage $V_W$ (typically 15—20 volts), the state of the cell (i.e. transistor $M_1$ conducting and transistor $M_2$ nonconducting or vice versa) is written into the cell in a non-volatile manner by the use of floating gates 15 and 16. Assume that cell 10 is programmed high (logical one) in a volatile manner such that transistor $M_1$ is off and transistor $M_2$ is on. The gate voltage $V_1$ is 5 volts. The drain 11-1 of transistor $M_1$ will then be high (at $V_W$), causing electrons to tunnel from the floating gate 15 of transistor $M_2$ to the drain 11-1 of transistor $M_1$, thereby lowering the threshold voltage of transistor $M_2$. Transistor $M_2$ is conducting and therefore the drain 12-1 of transistor $M_2$ is low. Thus no electrons will tunnel into or out of floating gate 16, and the threshold voltage of transistor $M_1$ is not affected. There is no tunnelling within the active structures of transistors $M_1$ and $M_2$ but rather only in the external tunnelling regions associated with the drains of these two transistors, because these are the only two regions of the device in which the oxide is thin enough (500—2000 nm) to permit tunnelling. Thus, the threshold voltage $V_{t2}$ of transistor $M_2$ is programmed to be less than the threshold voltage $V_{t1}$ of transistor $M_1$ which, as previously mentioned, corresponds to the non-volatile storage of a logical one in cell 10.

In a similar manner, if cell 10 is programmed low in a volatile manner such that transistor $M_1$ is on and transistor $M_2$ is off, when $V_{cc}$ is raised to the writing voltage $V_W$, drain 12-1 is high ($V_W$), thus causing electrons to tunnel from floating gate 16 of transistor $M_1$ to the drain 12-1 of transistor $M_2$, thereby lowering the threshold voltage of transistor $M_1$. Transistor $M_1$ is conducting and the drain 11-1 of transistor $M_1$ is low. Thus no electrons will tunnel into or out of floating gate 15, and the threshold voltage of transistor $M_2$ is not affected. Thus, the threshold voltage of transistor $M_1$ is programmed to be less than the threshold voltage of transistor $M_2$ which, as previously mentioned, corresponds to the nonvolatile storage of a logical zero in cell 10.

Once data has been stored in a non-volatile manner in memory cell 10, upon normal power-up of memory cell 10 by the application of $V_{cc}$ and $V_1$ to the circuit, the data stored in a non-volatile manner determines the initial state of cell 10. For example, if a logical 1 is stored in a non-volatile manner in cell 10 such that the threshold voltage of transistor $M_2$ is less than the threshold voltage of transistor $M_1$, upon the application of $V_{cc}$ (approximately 5 volts) and gate voltage $V_1$ (also approximately 5 volts) to gates 11 and 12 of transistors $M_1$ and $M_2$ respectively, transistor $M_2$ will turn on first, thereby lowering the voltage of drain 12-1 to ground. This low voltage on drain 12-1 is capacitively coupled through tunnel oxide to floating gate 16 of transistor $M_1$, thus causing transistor $M_1$ to remain off. Thus, transistor $M_2$ is on and transistor $M_1$ is off, corresponding to a logical one. In a similar fashion, if a logical 0 is stored in a non-volatile manner in memory cell 10 such that the threshold voltage of transistor $M_1$ is less than the threshold voltage of transistor $M_2$, upon power-up, transistor $M_1$ will turn on first, thereby lowering the voltage on drain 11-1 to ground. This low voltage on drain 11-1 is capacitively coupled through tunnel oxide to floating gate 15 of transistor $M_2$, thus preventing transistor $M_2$ from turning on, resulting in the flip-flop comprising transistors $M_1$ and $M_2$ being set to a logical zero.

Erasure of the data stored in cell 10 in a non-volatile manner is performed by increasing $V_1$ applied to gates 11 and 12 of transistors $M_1$ and $M_2$, respectively, to the erase voltage $V_E$ of approximately 20—25 volts. If $V_{cc}$ is five volts, then both $M_1$ and $M_2$ turn on, thereby ensuring equal drain voltages on these two devices. Tunnelling occurs such that the same amount of charge is stored on each floating gate and the circuit is balanced upon completion of erase. Erase, which corresponds to the tunnelling of electrons from the drains 11-1 and 12-1 of the transistors $M_1$ and $M_2$, respectively, to the floating gates 15 and 16, respectively, results in an increase in the threshold voltages of transistors $M_1$ and $M_2$. The actual threshold

voltages of $M_1$ and $M_2$ are varied by varying the magnitude and duration of the erase signal. It is not required to drive the threshold voltages of transistors $M_1$ and $M_2$ into heavy enhancement since the cell 10 is capable of operating in the depletion mode.

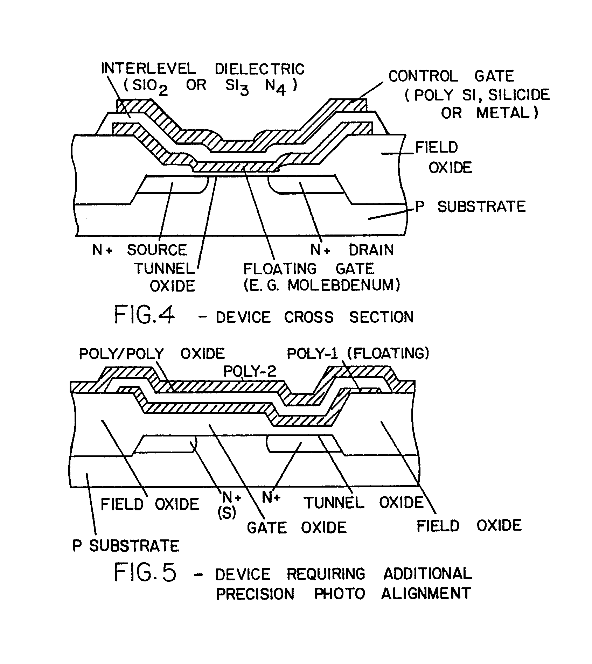

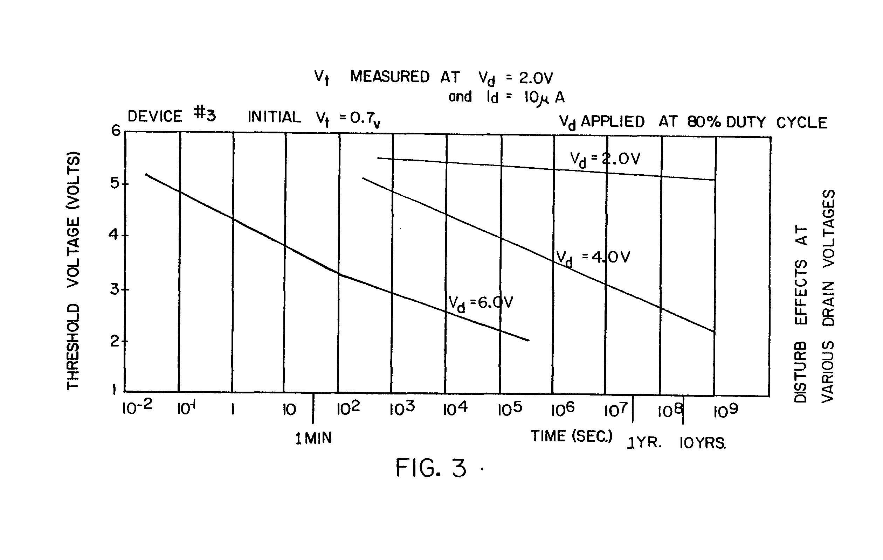

Since the floating gates 15 and 16 of transistors $M_2$ and $M_1$ are well insulated, the charge on the floating gates will hold the flip-flop in a static state for an extremely long period of time as shown in Figure 3. Figure 3 illustrates the floating gate voltage with respect to time for different levels of drain voltages. For a drain voltage of 2 volts, the effective threshold voltage of the device remains constant for in excess of $10^9$ seconds which corresponds to about 33 years. In this time, the voltage on the floating gate decays only by about 0.3 volts. Accordingly, this device has the ability to hold charge over an extremely long time. However, the charge can be easily erased by merely raising the voltage on lead 17 to a high level. The erasure occurs in a fraction of a second (typically about 100 milliseconds).

The cell of this invention, therefore, may be used in two modes, a non-volatile mode wherein the cell comprises a non-volatile static RAM and a volatile mode in which the flip-flop operates as a volatile static RAM cell. However if desired, volatile data can be stored non-volatily provided the cell has already been erased. To do this, prior to powering down, $V_{cc}$ is raised to $V_w$ for a few milliseconds. The volatile data in the cell is converted to non-volatile data through the tunnelling of electrons in the manner described above. The cell's floating gates therefore retain in a non-volatile manner the electrons indicative of the volatile state of the cell prior to powering down. As shown in Figure 3, the cell can hold this data for many years, if necessary. As a feature of this invention, the data transfer to non-volatile storage occurs simultaneously for all bits in the memory.

Suitable circuitry (not shown) can be utilized for determining when power-down is about to occur. For example, circuitry can be used which determines when $V_{cc}$ drops to a predetermined level below normal. Alternatively, a suitable signal may be provided by the system (such as a computer system, for example) in which the memory cell of this invention is utilized, thus instructing memory cell 10 to write the volatile data in the cell in a non-volatile manner, as described above. The writing voltage $V_w$ may be provided during power-down by a capacitor, for example, which has been charged during normal powered operation of the memory cell 10.

As an additional feature of this invention, two bits may be stored in each cell, one comprising a volatile storage and the other a non-volatile storage. Thus, the cell can be operated as a volatile static memory cell in the standard manner but additionally can have stored on the floating gates of each cell a bit of data corresponding to a different state (for example, "bootstrap" data to be utilized upon initialization or power-up of the device). The cell is then operated by ensuring that the drive voltages used to operate the cell in its volatile storage mode are sufficient to overcome the non-volatile information stored in the cell.

The enhancement of the state of the cell due to a disturb voltage is illustrated by assuming $M_1$ to be on and $M_2$ to be off. Of importance, most voltage disturbances encountered in memory devices such as the memory cell 10 of this invention are sudden increases in voltage, rather than decreases in voltage. When $M_2$ is off, the voltage on drain 12-1 of transistor $M_2$ is high, approximately $V_{cc}$, while the voltage on the drain 11-1 of transistor $M_1$ is low, approximately ground. Should $V_{cc}$ be driven high by a disturbance, the effect is to remove electrons from floating gate 16, thereby turning on transistor $M_1$ harder and reinforcing the state of the circuit. Floating gate 15 is not affected because it is connected through tunnel oxide to the drain 11-1 of transistor $M_1$ which is substantially at ground. Should $V_1$ (the gate voltage on lead 17) go substantially positive, the effect is to draw further electrons onto floating gate 15, thereby further turning off transistor $M_2$. $V_1$ will have little effect on floating gate 16 because this floating gate is connected through tunnel oxide to a high potential on the drain 12-1 of transistor $M_2$ and an increase in the voltage $V_1$ merely reduces the difference between the potential on floating gate 16 and $V_{cc}$. Thus, it is seen that the normal disturbing voltages are in such a direction as to enhance the storage of information in the cell rather than degrade the storage of information. Of course, if the non-volatile bit is opposite to the volatile bit, the non-volatile bit state is degraded rather than enhanced by positive disturb voltages on $V_{cc}$.

Figure 4 illustrates in cross section a semiconductor device particularly suited for implementing the structure shown in Figure 1. P-type substrate (typically <100> material with a resistivity of 2—50 Ω-cm) has formed in it N+ source and drain regions using well-known processing techniques. Formed over the surface of the active region of the device is a gate oxide and formed over the gate oxide is a floating gate of a conductive material such as doped polycrystalline silicon or molybdenum. On top of the floating gate is formed dielectric (typically silicon dioxide or silicon nitride) and on top of this dielectric is formed a control gate. The control gate is again formed of doped polycrystalline silicon, a silicide or selected metal such as aluminum and is capacitively coupled to the floating gate. As shown in Figure 5b, the tunnelling oxide portion is formed directly over the drain such that electrons can tunnel in response to the proper voltages applied to the drain and the floating gate from one to the other. Overlying the floating gate but separated therefrom by dielectric is a control gate typically formed of doped polycrystalline silicon. This control gate is capacitively coupled to the floating gate so as to control the potential of the floating gate.

Other embodiments of this invention will be obvious to those skilled in the art in view of this disclosure.

**Claims**

1. An electronic memory having a plurality of memory cells, each memory cell comprising:

a first MOS transistor (M1) and a second MOS transistor (M2), each MOS transistor possessing a source, a drain and a control gate;

a first floating gate (16) positioned between the gate (11) and the channel of said first MOS transistor (M1) but insulated therefrom and having a portion extending above but separated by dielectric from the drain (12-1) of said second transistor (M2), said dielectric having a portion thereof sufficiently thin to allow electrons to tunnel therethrough between the drain (12-1) of said second transistor (M2) and said first floating gate (16); and

a second floating gate (15) positioned between the gate (12) and the channel of said second MOS transistor (M2) but insulated therefrom and having a portion extending above but separated by dielectric from the drain (11-1) of said first transistor (M1), said dielectric having a portion thereof sufficiently thin to allow electrons to tunnel therethrough between the drain (11-1) of said first transistor (M1) and said second floating gate (15); characterized in that:

the sources of the two MOS transistors (M1, M2) are coupled and the control gates (11, 12) of said two MOS transistors are connected to a source of gate potential; and in that the memory cell further comprises:

a pair of resistive elements (R1, R2), one lead of each resistive element being connected to a corresponding drain (11-1, 12-1) of one of said MOS transistors (M1, M2), the other lead of each resistive element being connected to a voltage source ($V_{cc}$); and means (13) connected to the drain (11-1) of a selected one of said two transistors (M1, M2) for providing a signal to said memory cell;

said electronic memory including means ($V_{cc}$) for raising the voltage across each memory cell to a writing voltage ($V_w$) for storing in a non-volatile manner data that was stored in said cell in a volatile manner, said data being stored in said non-volatile manner in the same state as the data stored in a volatile manner.

2. Memory of claim 1, characterized in that said MOS transistors (M1, M2) comprise N-channel MOS transistors and said floating gates (15, 16) comprise polycrystalline silicon.

3. Memory of claim 1 or 2, characterized in that the portions of said dielectric are sufficiently thin to allow electrons to tunnel therethrough between said first floating gate (16) and the drain (12-1) of said second transistor (M2) and between said second floating gate (15) and the drain (11-1) of said first transistor (M1) comprises silicon dioxide between about 500 to 2200 nm (50 to 220 angstroms) thick.

4. Memory of claim 1, 2 or 3, characterized in that one data bit can be stored in each cell in a volatile manner and another data bit can be stored in said cell in a non-volatile manner.

**Patentansprüche**

1. Ein elektronischer Speicher mit einer Mehrzahl von Speicherzellen, von denen jede umfaßt:

einen ersten MOS-Transistor (M1) und einen zweiten MOS-Transistor (M2), von denen jeder eine Source, ein Drain und ein Gate besitzt,

ein erstes schwimmendes Gate (16), positioniert zwischen dem Gate (11) und dem Kanal des ersten MOS-Transistors (M1), jedoch davon isoliert und versehen mit einem Abschnitt, der sich über den Drain (12-1) des zweiten Transistors erstreckt, jedoch von diesem durch Dielektrikum isoliert ist, welches einen hinreichend dünnen Abschnitt aufweist, daß er von Elektronen durchtunnelt werden kann zwischen dem Drain (12-1) des zweiten Transistors (M2) und dem ersten schwimmenden Gate (16), und

ein zweites schwimmendes Gate (15), positioniert zwischen dem Gate (12) und dem Kanal des zweiten MOS-Transistors (M2), jedoch davon isoliert und versehen mit einem Abschnitt, der sich über den drain (11-1) des ersten Transistors erstreckt, jedoch von diesem durch dielektrikum isoliert ist, welches einen hinreichend dünnen Abschnitt aufweist, daß er von Elektronen durchtunnelt werden kann zwischen dem Drain (11-1) des ersten Transistors (M1) und dem zweiten schwimmenden Gate (15), dadurch gekennzeichnet, daß:

die Source' der beiden MOS-Transistoren (M1, M2) gekoppelt sind und die Steuergates (11, 12) der beiden MOS-Transistoren an eine Quelle von Gate-Potential angeschlossen sind, und daß die Speicherzelle ferner imfaßt:

ein Paar resistiver Elemente (R1, R2), wobei eine Zuleitung jedes resistiven Elements an einen zugeordneten Drain (11-1, 12-1) eines der MOS-Transistoren angeschlossen ist, die andere Zuleitung jedes resistiven Elements an eine Spannungsquelle ($V_{cc}$) angeschlossen ist, und Mittel (13) an den Drain (11-1) eines ausgewählten der beiden Transistoren (M1, M2) angeschlossen sind für die Übertragung eines Signals zu der Speicherzelle,

welcher elektronische Speicher Mittel ($V_{cc}$) umfaßt für das Anheben der Spannung über jeder Speicherzelle auf eine Schreibspannung ($V_w$) zum nicht-flüchtigen Speichern von Daten, die in der Zelle flüchtig gespeichert waren, welche nicht-flüchtig gespeicherten Daten in demselben Status gespeichert werden wie die flüchtig gespeicherten Daten.

2. Speicher nach Anspruch 1, dadurch gekennzeichnet, daß die MOS-Transistoren (M1, M2) N-Kanal-MOS-Transistoren umfassen und die schwimmenden Gates (15, 16) polykristallines Silizium umfassen.

3. Speicher nach Anspruch 1 oder 2, dadurch gekennzeichnet, daß die Abschnitte des Dielektrikums, die hinreichend dünn sind, daß sie von Elektronen durchtunnelt werden können zwischen dem ersten schwimmenden Gate (16) und dem Drain (12-1) des zweiten Transistors (M2) und zwischen dem zweiten schwimmenden Gate (15) und dem Drain (11-1) des ersten Transistors (M1), Siliziumdioxid einer Dicke zwischen etwa 500 bis 220 nm (50 bis 220 Angström) umfassen.

4. Speicher nach Anspruch 1, 2 oder 3, dadurch gekennzeichnet, daß ein Datenbit in jeder Zelle flüchtig gespeichert werden kann und ein anderes Datenbit in der Zelle nicht-flüchtig gespeichert werden kann.

**Revendications**

1. Mémoire électronique ayant une pluralité de cellules de mémoire chaque cellule de mémoire comprenant:

un premier transistor MOS (M1) et un second transistor MOS (M2), chaque transistor MOS ayant une source, un drain et une porte de commande;

une première porte flottante (16) disposée entre la porte (11) et le canal dudit premier transistor MOS (M1) mais isolée de celui-ci et ayant une partie s'étendant en-dessus du drain (12-1) dudit second transistor (M2), mais séparée de celui-ci par un diélectrique, ledit diélectrique ayant une partie suffisamment mince pour permettre aux électrons de tunneller à travers lui entre le drain (12-1) dudit second transistor (M2) et ladite première porte flottante (16); et

une seconde porte flottante (15) disposée entre la porte (12) et le canal dudit second transistor MOS (M2) mais isolée de celui-ci et ayant une partie s'étendant en-dessus du drain (11-1) dudit premier transistor (M1), mais séparée de celui-ci par un diélectrique ledit, diélectrique ayant une partie de ce dernier suffisamment mince pour permettre aux électrons de tunneller à travers lui entre le drain (11-1) dudit premier transistor (M1) et ladite seconde porte flottante (15), caractérisée en ce que:

les sources des deux transistors MOS (M1, M2) sont reliées et les portes de commande (11, 12) desdits deux transistors MOS sont reliées à une source d'un potentiel de porte; et en ce que la cellule de mémoire comprend en outre:

une paire d'éléments résistifs (R1, R2), un conducteur de chaque élément résistif étant relié à un drain correspondant (11-1, 12-1) d'un desdits transistors MOS (M1, M2), l'autre conducteur de chaque élément résistif étant relié à une source de tension ($V_{cc}$); et des moyens (13) reliés au drain (11-1) de l'un desdits deux transistors (M1, M2) pour fournir un signal à ladite cellule de mémoire,

ladite mémoire électronique comprenant des moyens ($V_{cc}$) pour augmenter la tension aux bornes de chaque cellule de mémoire jusqu'à une tension d'écriture ($V_w$) pour stocker de façon non volatile une donnée qui a été stockée dans ladite cellule d'une façon volatile, ladite donnée étant stockée de ladite façon non volatile dans le même état que la donnée stockée de façon volatile.

2. Mémoire selon la revendication 1, caractérisée en ce que lesdits transistors MOS (M1, M2) comprennent des transistors MOS à canal N et lesdites portes flottantes (15, 16) comprennent du silicium polycristallin.

3. Mémoire selon la revendication 1 ou 2, caractérisée en ce que les parties dudit diélectrique sont suffisamment minces pour permettre aux électrons de tunneller à travers lui entre ladite première porte flottante (16) et le drain (12-1) dudit second transistor (M2) et entre ladite seconde porte flottante (15) et le drain (11-1) desdits premiers transistors (M1) et comprenent une épaisseur de dioxyde de silicium s'étendant de 500 à 2,200 nm.

4. Mémoire selon la revendication 1, 2 ou 3, caractérisée en ce qu'un bit de donnée peut être stocké dans chaque cellule d'une façon volatile et un autre bit de donnée peut être stocké dans ladite cellule d'une façon non volatile.

M₁ DRAIN M₂ DRAIN

18

FLOATING
GATE 15

11-1

( POLY OR
REFRACTORY
METAL )

16

12-1

11

12

M₁ M₂ V₁

ERASING
GATE
( POLY )

14

Vss DIFFUSION

REPRESENTS THIN TUNNELING OXIDE
UNDER FLOATING GATE

( SHOWN AS |← IN FIG. 1 )

FIG. 2   LAYOUT OF CROSS-COUPLED
FLOATING GATES

V_CC

10

R₁

R₂

13

Y

18

X

15

16

11-1

14

12-1

M₁

11

12

M₂

17

V₁

FIG. 1

CELL ELECTRICAL
CONFIGURATION

EP 0 080 415 B1

INTERLEVEL DIELECTRIC
(SIO$_2$ OR SI$_3$N$_4$)

CONTROL GATE
(POLY SI, SILICIDE
OR METAL)

FIELD
OXIDE

P SUBSTRATE

N+ SOURCE

TUNNEL
OXIDE

N+ DRAIN

FLOATING GATE
(E.G. MOLEBDENUM)

FIG.4 – DEVICE CROSS SECTION

POLY/POLY OXIDE

POLY-1 (FLOATING)

POLY-2

FIELD OXIDE

N+
(S)

N+

TUNNEL OXIDE

GATE OXIDE

FIELD OXIDE

P SUBSTRATE

FIG.5 – DEVICE REQUIRING ADDITIONAL
PRECISION PHOTO ALIGNMENT

2

FIG. 3 .